Europäisches Patentamt

European Patent Office

Office européen des brevets

(19)

(11) Numéro de publication: **0 034 530**

**A1**

(12)

# DEMANDE DE BREVET EUROPEEN

(21) Numéro de dépôt: **81400208.5**

(22) Date de dépôt: **10.02.81**

(51) Int. Cl.³: **H 05 K 3/34**

(30) Priorité: **15.02.80 FR 8003413**

(43) Date de publication de la demande:
**26.08.81 Bulletin 81/34**

(84) Etats contractants désignés:
**BE DE GB IT NL**

(71) Demandeur: **COMPAGNIE INDUSTRIELLE POUR LES TECHNIQUES ELECTRONIQUES**
**25, rue de Courcelles**
**F-75008 Paris(FR)**

(72) Inventeur: **Sevestre, Alain**
**THOMSON-CSF SCPI 173, bld Haussmann**
**F-75360 Paris Cedex 08(FR)**

(74) Mandataire: **Benoit, Monique et al,**
**"THOMSON-CSF" - SCPI 173, bld Haussmann**
**F-75360 Paris Cedex 08(FR)**

(54) Procédé de fixation de composants électroniques sur un circuit imprimé, et produit obtenu par ce procédé.

(57) L'invention a pour objet un procédé de fixation de composants électroniques, notamment des composants dépourvus de pattes de connexion, sur un circuit imprimé double face ou multicouches. Ce procédé comporte principalement les étapes suivantes:

- la préparation (1) des composants, comportant notamment une étape de protection (11) des composants en dehors de leurs zones de connexion;
- le montage (2) des composants sur le circuit imprimé et leur immobilisation à l'aide d'un collage (22) et d'un ou plusieurs points de soudure (23);
- le soudage (3) collectif de tous les composants par immersion des composants dépourvus de pattes dans un bain de soudure;
- le nettoyage (4) du circuit imprimé et de ses composants, notamment par suppression (42) du matériau de protection de la première étape.

./...

## FIG.1

```
1 ┤
    ┌─────────────────────────────┐
    │  PROTECTION              ─11 │
    │  DES COMPOSANTS              │
    │         ↓                    │
    │  FLUXAGE                 ─12 │
    │         ↓                    │
    │  PRE-ETAMAGE             ─13 │
    └─────────────────────────────┘
               ↓
2 ┤
    ┌─────────────────────────────┐
    │  POSITIONNEMENT          ─21 │
    │         ↓                    │
    │  COLLAGE                 ─22 │
    │         ↓                    │
    │  SOUDURE PAR POINTS      ─23 │
    └─────────────────────────────┘
               ↓
3 ┤  SOUDAGE COLLECTIF
               ↓
4 ┤
    ┌─────────────────────────────┐
    │  NETTOYAGE CHIMIQUE      ─41 │
    │         ↓                    │
    │  DISSOLUTION DE LA       ─42 │
    │  COUCHE PROTECTRICE          │
    └─────────────────────────────┘
```

# PROCEDE DE FIXATION DE COMPOSANTS ELECTRONIQUES SUR UN CIRCUIT IMPRIME ET PRODUIT OBTENU PAR CE PROCEDE

La présente invention a pour objet un procédé de fixation de composants électroniques sur un circuit imprimé, permettant, par une opération de soudure collective, de fixer sur un circuit imprimé à la fois des composants discrets, des circuits intégrés et des composants de type circuits intégrés mais dépourvus de pattes de connexion, connus dans la littérature anglo-saxonne sous le nom de "chips carriers".

Ces composants "chips carriers", du fait de leur structure particulière sans pattes de connexion mais avec un nombre élevé de points de soudage (typiquement de 16 à 84 points), posent des problèmes technologiques nouveaux pour leur fixation sur des circuits imprimés. Différentes solutions sont déjà connues, parmi lesquelles on peut citer :

- la soudure point par point du composant sur le circuit à l'aide d'un rayon laser, par une machine automatique ; cette solution présente l'inconvénient d'une grande complexité ;

- la soudure collective en phase vapeur de tous les composants de ce type montés sur le circuit imprimé ; l'inconvénient de cette solution est qu'elle ne convient qu'à des circuits imprimés portant exclusivement des composants du type "chips carriers" ;

- la soudure également collective mais à l'aide de fours et d'étuves des composants de ce type montés sur le circuit imprimé ; cette solution présente le même inconvénient que la solution précédente.

En outre, ces différentes méthodes nécessitent des temps de soudage élevés, ce qui est un autre inconvénient.

La présente invention a pour objet un procédé simple et rapide permettant d'éviter les difficultés précédentes et ne nécessitant aucun matériel supplémentaire par rapport aux diverses méthodes de soudure collective connues.

Plus précisément, le procédé selon l'invention comporte principalement les étapes suivantes :

- la préparation des composants à fixer sur le circuit imprimé, comportant éventuellement une étape de protection des composants, en dehors des zones de connexion, par un matériau susceptible d'être supprimé dans une phase ultérieure ;

- le montage de ces composants et leur immobilisation sur le circuit imprimé ;

- le soudage collectif de tous les composants ainsi montés par immersion des composants dépourvus de pattes de connexion dans un bain de soudure ;

- le nettoyage du circuit imprimé et des composants qu'il porte, notamment par la suppression du matériau de protection éventuellement déposé lors de la première étape ci-dessus.

D'autres objets, caractéristiques et résultats de la présente invention ressortiront de la description suivante, illustrée par les dessins annexés qui représentent :

- la figure 1, schématiquement le déroulement du procédé selon l'invention ;

- la figure 2, a, b et c, un circuit imprimé sur lequel sont fixés différents types de composants par le procédé selon l'invention.

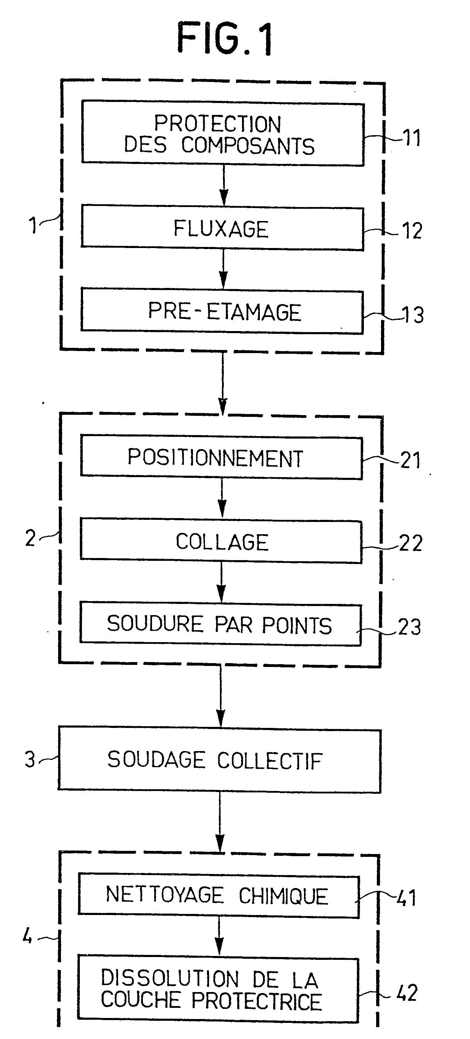

Sur la figure 1 sont représentées les quatre principales étapes du procédé selon l'invention, à savoir, successivement :

- une première étape (1) de préparation des composants à fixer sur un circuit imprimé ;

- une deuxième étape (2) pendant laquelle les composants sont montés et immobilisés sur le circuit imprimé ;

- une troisième étape (3) consistant à souder collectivement les composants précédemment montés, et enfin

- une dernière étape (4) de nettoyage du circuit imprimé et des composants ainsi soudés.

La première étape (1) se décompose de préférence en trois sous-étapes successives, repérées 11, 12 et 13, qui sont les suivantes :

3

- la protection (étape 11) des parties métalliques des composants qui ne doivent pas être soudés, ainsi que les parties portant les marquages et les références du composant considéré, qui peuvent être ou non métalliques. Cette protection est par exemple réalisée à l'aide d'une solution polymérisable à température ambiante, à chaud ou encore aux rayons ultra-violets ; cette couche de protection est de préférence résistante aux solvants ou plus généralement aux produits chimiques utilisés dans les étapes ultérieures. La nécessité de cette étape est liée au fait que les composants dépourvus de pattes sont immergés dans le bain de soudure, ainsi qu'il est décrit ci-après (étape 3) ;

- une opération classique de fluxage (étape 12), pendant laquelle est déposé sur les surfaces métàlliques à souder un matériau isolant dont la température de décomposition est inférieure à la température de soudure, ce qui permet d'éviter l'oxydation de la surface à souder. Dans un mode de réalisation préféré, l'ensemble du composant est plongé dans un bain par exemple de résine ;

- une opération de préétamage (étape 13), pendant laquelle le composant est plongé par exemple dans un bain de brasage constitué par un alliage d'étain et de plomb. Cette étape est destinée à améliorer la qualité de la soudure du composant sur le circuit imprimé.

L'étape 2 de montage des composants sur le circuit imprimé se décompose également en trois sous-étapes successives, repérées 21, 22 et 23.

L'étape 21 consiste à placer les composants sur le circuit imprimé. Elle est suivie par l'étape 22 de collage de ces composants à l'aide d'une colle susceptible d'être dissoute par des solvants chimiques. Le composant est ensuite (étape 23) soudé au fer en un ou plusieurs points sur le circuit imprimé, de préférence deux points, afin d'être centré et maintenu pendant le séchage de la colle. Cette étape de soudure par points présente l'avantage de réaliser un autocentrage du composant par rapport aux pistes conductrices du circuit imprimé, les parties métalliques du composant et du circuit, réunies par la soudure, ayant tendance à se placer exactement en face les unes des autres, ce qui est particulièrement intéressant du fait de la petitesse des dimensions concernées.

Lors de l'étape 3 est réalisé le soudage collectif des différents composants préalablement (étape 2) montés sur le circuit imprimé, par immersion des composants dépourvus de pattes de connexion dans un bain de soudure. Ce soudage est réalisé par une méthode connue telle que la soudure à vague ou le bain mort, le bain de soudure devant être compatible avec le bain de préparation de l'étape 13.

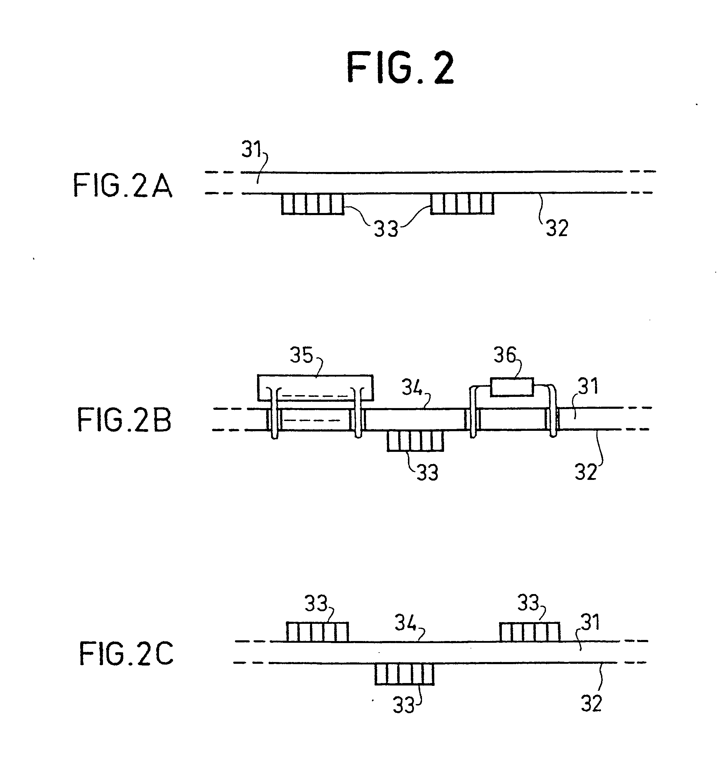

A titre d'exemple, on a représenté sur la figure 2 différentes configurations possibles pour les composants sur le circuit imprimé.

Sur la figure 2a, on a représenté, vu en coupe, un circuit imprimé 31 sur lequel sont montés deux composants 33, dépourvus de pattes de connexion, sur la même face (32) du support 31. Lors de l'opération de soudure de l'étape 3, c'est alors la face 32 qui est plongée dans le bain de soudure.

Sur le schéma b de la figure 2, on a représenté une variante dans laquelle le circuit imprimé 31 est un circuit double face, ou multicouches, portant plusieurs types de composants : on retrouve sur la face 32 uniquement des composants sans pattes 33, mais sur l'autre face (34) sont disposés soit des circuits imprimés (35), soit des composants discrets quelconques (36), dont les pattes traversent le circuit 31. Dans ce cas, comme précédemment, le circuit imprimé 31 est en contact avec le bain de soudure par sa face 32 uniquement. Ici apparaît un autre avantage très important de l'invention, à savoir que l'ensemble des composants des deux faces peuvent être ainsi soudés durant une seule et même opération de soudure collective telle que celle de l'étape 3.

Le schéma de la figure 2c représente une variante dans laquelle le circuit imprimé 31 porte des composants sans pattes 33 sur ses deux faces, 32 et 34. Dans ce cas, la soudure de l'ensemble des composants nécessite deux opérations telles que décrites étape 3, c'est-à-dire une première soudure collective des composants

5

placés sur la face 32, par immersion de cette face dans le bain de soudure, suivie de façon analogue par une seconde soudure collective des composants placés sur la face 34.

Le procédé décrit figure 1 se termine par l'étape 4 de nettoyage du circuit obtenu. Elle se décompose en une première sous-étape (41), classique, de nettoyage chimique du circuit, suivie par une sous-étape 42 durant laquelle le produit de protection de l'étape 11 est enlevé, par exemple au trempé à froid, à chaud ou en phase vapeur. L'étape 42 n'est bien entendu nécessaire que dans le cas où l'étape 11 a été effectivement réalisée.

En conclusion, le procédé décrit ci-dessus permet en une seule opération la soudure collective à la fois de tous les points de connexion de composants dépourvus de pattes de connexion, par immersion de ceux-ci dans le bain de soudure, et de toutes les pattes de connexion de composants du type discret ou circuit intégré situés de l'autre côté du circuit imprimé, ce qui conduit à une diminution du nombre des opérations et un gain de temps par rapport aux procédés connus. De plus, l'apport de soudure réalisé dans ce procédé sur les points de connexion des composants permet d'améliorer la résistance de ces connexions aux chocs thermiques.

6

## <u>R E V E N D I C A T I O N S</u>

1. Procédé de fixation de composants électroniques sur un circuit imprimé, une partie au moins de ces composants étant dépourvue de pattes de connexion, ce procédé étant caractérisé par le fait qu'il comporte successivement les étapes suivantes :

- la préparation des composants (1), comportant une étape de protection (11) des composants en dehors de leurs zones de connexion par un matériau de protection ;

- le montage et l'immobilisation (2) des composants sur le circuit imprimé, comportant les étapes suivantes :

- le positionnement (21) des composants sur le circuit imprimé ;

- le collage (22) de ces composants sur le circuit imprimé ;

- la fixation par soudure en au moins un point de ces composants sur le circuit ;

- le soudage (3) collectif des composants par immersion des composants dépourvus de pattes de connexion dans un bain de soudure ;

- le nettoyage (4) du circuit imprimé et des composants qu'il porte, assurant la suppression du matériau de protection.

2. Procédé selon la revendication 1, caractérisé par le fait que la première étape (1) comporte en outre, après l'étape de protection (11), une étape de fluxage (12) puis une étape de préétamage (13) des composants.

3. Procédé selon la revendication 1, caractérisé par le fait que le matériau de protection est constitué par un liquide polymérisable.

4. Produit obtenu par le procédé selon l'une des revendications précédentes, caractérisé par le fait que le circuit imprimé est un circuit du type double face ou multicouches, les composants dépourvus de pattes de connexion étant montés sur une même face du circuit, cette face étant celle qui est immergée dans le bain de soudure lors de l'étape de soudage collectif (3).

5. Produit obtenu par le procédé selon l'une des revendications précédentes, caractérisé par le fait que le circuit imprimé est un circuit du type double face ou multicouches et qu'il comporte des composants munis de pattes de connexion sur l'une de ses faces et des composants dépourvus de pattes de connexion sur l'autre face, cette dernière face étant celle qui est immergée dans le bain de soudure lors de l'étape de soudage collectif (3).

0034530

# FIG.1

```
┌ ─ ─ ─ ─ ─ ─ ─ ─ ─ ─ ─ ─ ─ ┐
    ┌─────────────────────┐
    │      PROTECTION      │ ─── 11
    │   DES COMPOSANTS     │
    └─────────────────────┘
1              │
    ┌─────────────────────┐
    │       FLUXAGE        │ ─── 12
    └─────────────────────┘
               │
    ┌─────────────────────┐
    │     PRE-ETAMAGE      │ ─── 13
    └─────────────────────┘
└ ─ ─ ─ ─ ─ ─ ─ ─ ─ ─ ─ ─ ─ ┘

┌ ─ ─ ─ ─ ─ ─ ─ ─ ─ ─ ─ ─ ─ ┐
    ┌─────────────────────┐
    │    POSITIONNEMENT    │ ─── 21
    └─────────────────────┘
2              │
    ┌─────────────────────┐
    │       COLLAGE        │ ─── 22
    └─────────────────────┘
               │
    ┌─────────────────────┐
    │  SOUDURE PAR POINTS  │ ─── 23
    └─────────────────────┘
└ ─ ─ ─ ─ ─ ─ ─ ─ ─ ─ ─ ─ ─ ┘

    ┌─────────────────────┐
3   │  SOUDAGE COLLECTIF   │
    └─────────────────────┘
               │
┌ ─ ─ ─ ─ ─ ─ ─ ─ ─ ─ ─ ─ ─ ┐
    ┌─────────────────────┐
    │  NETTOYAGE CHIMIQUE  │ ─── 41
    └─────────────────────┘
4              │
    ┌─────────────────────┐
    │  DISSOLUTION DE LA   │ ─── 42
    │  COUCHE PROTECTRICE  │
    └─────────────────────┘
└ ─ ─ ─ ─ ─ ─ ─ ─ ─ ─ ─ ─ ─ ┘
```

# FIG.2

FIG.2A

31
33
32

FIG.2B

35
36
34
31
33
32

FIG.2C

33
34
33
31
33
32

**0034530**

Numéro de la demande

**Office européen des brevets**

**RAPPORT DE RECHERCHE EUROPEENNE**

EP 81 40 0208

## DOCUMENTS CONSIDERES COMME PERTINENTS

| Catégorie | Citation du document avec indication, en cas de besoin, des parties pertinentes | Revendica-tion concernée |
|---|---|---|
| X | <u>DE - A - 2 755 926</u> (MATSUSHITA ELECTIC INDUSTRIAL CO.) <br> * Revendications, page 11, alinéas 2-4; page 12, figures 1-4 * <br><br> --- | 1-5 |

**CLASSEMENT DE LA DEMANDE (Int. Cl.³)**

H 05 K 3/34

**DOMAINES TECHNIQUES RECHERCHES (Int. Cl.³)**

H 05 K 3/34
13/04
3/30

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 25-05-1981 | VAN REETH |

OEB Form 1503.1   06.78